# EUROPEAN PATENT APPLICATION

(11) **EP 4 787 632 A1**
(43) Date of publication of application: **05.08.2026**
(21) Application number: 25213618.9
(22) Date of filing: 05.11.2025
(51) Int. Cl.: H01R 13/52, H01M 50/296, H01R 13/74, H05K 7/14

(54) **CONNECTOR ASSEMBLY STRUCTURE**

(30) Priority: 31.01.2025 JP 2025015643
(71) Applicant: TOYOTA JIDOSHA KABUSHIKI KAISHA, Toyota-shi, Aichi-ken 471-8571 (JP)
(72) Inventor: INOUE, Yuya, Toyota-shi, Aichi-ken 471-8571 (JP); KAWAMOTO, Naoya, Toyota-shi, Aichi-ken 471-8571 (JP); YAMANAKA, Atsushi, Toyota-shi, Aichi-ken 471-8571 (JP)
(74) Representative: Winter, Brandl - Partnerschaft mbB

(57) **Abstract**

A connector assembly structure includes equipment, a lower case including an equipment placement portion on which the equipment is placed and one or a plurality of connector seats provided at a position that is adjacent to the equipment placement portion, a connector that is connected to the equipment via a cable, and that includes a connector body in which a terminal is housed, and a positioning portion that is provided on the connector body and that engages the connector seat to position the connector, an upper case that covers an upper portion of the lower case, and that has a window portion to which the connector is attached, and a fixing member that is attached to a periphery of the window portion from outside of the upper case, and that moves the connector in a direction away from the connector seat and fixes the connector to the upper case.

## Description

### BACKGROUND OF THE INVENTION

### 1. Field of the Invention

The technology of the present disclosure relates to a connector assembly structure.

### 2. Description of Related Art

Vehicles, particularly vehicles such as battery electric vehicles and hybrid electric vehicles, employ various connectors for electrically connecting components.

Japanese Unexamined Patent Application Publication No. 2024-004006 (JP 2024-004006 A) discloses an arrangement in which equipment and an external device are electrically connected, using a connector including a first connector that is attached to a housing of the equipment and a second connector that is assembled to the first connector.

### SUMMARY OF THE INVENTION

There are various methods for assembling a connector to connect inside of a housing that is closed off, an outside thereof. For example, one conceivable method is to bring a lid that closes the housing, in which equipment is housed, into close proximity with the housing, in which state a connector that is connected to the equipment is fixed to the lid, or in which a connector connected to external equipment is fixed to the lid and then to connect a connector that is connected to the equipment to this connector in a state of bringing the lid into close proximity with the housing. However, in each assembly that is described above, there is a need to perform work such as fixing the connector or connecting another connector, in a state of supporting the lid in close proximity with the housing, and accordingly there is room for improvement in terms of ease of work. Also, the above-described work requires moving the connector that is connected to the equipment, and accordingly there is a need to ensure a relatively great amount of slack in a cable connecting the equipment and the connector.

In view of the above-described problems, an object of the present disclosure is to provide a connector assembly structure of which ease of work of assembly is enhanced.

In order to achieve the above object, a connector assembly structure according to a first aspect includes equipment, a lower case including an equipment placement portion on which the equipment is placed and one or a plurality of connector seats provided at a position that is adjacent to the equipment placement portion, a connector that is connected to the equipment via a cable, and that includes a connector body in which a terminal is housed, and a positioning portion that is provided on the connector body and that engages the connector seat to position the connector, an upper case that covers an upper portion of the lower case, and that has a window portion to which the connector is attached, and a fixing member that is attached to a periphery of the window portion from outside of the upper case, and that moves the connector in a direction away from the connector seat and fixes the connector to the upper case.

In the connector assembly structure according to the first aspect, the connector that is located inside the upper case can be fixed to the upper case by the fixing member that is attached from the outside of the upper case, and accordingly ease of work of fixing the connector to the upper case is enhanced.

With the connector assembly structure according to a second aspect, the connector assembly structure according to the first aspect, further includes a seal member that is provided in at least one of a position of the connector body facing the upper case or a position of the upper case facing the connector body.

In the connector assembly structure of the second aspect, a gap between the upper case and the connector body can be done away with.

With the connector assembly structure according to a third aspect, in the connector assembly structure according to the first or second aspect, the connector body includes a flange extending from an outer peripheral face of the connector body in a direction intersecting with an extension direction of the terminal, and the positioning portion is provided on the flange.

According to the connector assembly structure of the third aspect, the connector can be positioned on the connector seat without reducing the degree of freedom in design thereof.

With the connector assembly structure according to a fourth aspect, in the connector assembly structure according to any one of the first to third aspects, the connector seat includes a recessed portion or a projection on a face that comes into contact with the connector, and the positioning portion includes a projection or a recessed portion that fits with the recessed portion or the projection that is fashioned in the connector seat.

According to the connector assembly structure of the fourth aspect, positioning of the connector to the connector seat can be realized with a simple structure.

According to the above-described connector assembly structure, ease of work of assembly is enhanced.

### BRIEF DESCRIPTION OF THE DRAWINGS

Features, advantages, and technical and industrial significance of exemplary embodiments of the invention will be described below with reference to the accompanying drawings, in which like signs denote like elements, and wherein:
FIG. 1 is a perspective view illustrating an example of a power storage device including a connector assembly structure according to an embodiment;
FIG. 2 is a disassembled view of the principal portions of the connector assembly structure illustrated in FIG. 1, illustrated in an enlarged manner;
FIG. 3 is a flowchart showing an assembly process of the connector assembly structure illustrated in FIG. 2;
FIG. 4A is an explanatory diagram illustrating a state of the connector assembly structure when performing the assembly process shown in FIG. 3;
FIG. 4B is an explanatory diagram illustrating a state of the connector assembly structure when performing the assembly process shown in FIG. 3;
FIG. 5A is an explanatory diagram illustrating a state of the connector assembly structure when performing the assembly process shown in FIG. 3;
FIG. 5B is an explanatory diagram illustrating a state of the connector assembly structure when performing the assembly process shown in FIG. 3;
FIG. 6A is an explanatory diagram illustrating a state of the connector assembly structure when performing the assembly process shown in FIG. 3; and
FIG. 6B is an explanatory diagram illustrating a state of the connector assembly structure when performing the assembly process shown in FIG. 3.

### DETAILED DESCRIPTION OF EMBODIMENTS

Embodiments for carrying out the present disclosure will be described below with reference to the drawings. Note that in the following, the scope of description necessary for achieving the object of the present disclosure will be set forth schematically, the scope necessary for description of relevant portions of the present disclosure will be mainly described, and portions in which description is omitted is based on known technology. Also, the same or similar symbols are used for parts that are the same as or corresponding to each other in the drawings, and repetitive description will be omitted. Further, when a number of identical or corresponding components are included in a drawing, only some of them may be denoted with reference numerals, in order to facilitate viewing of the drawing.

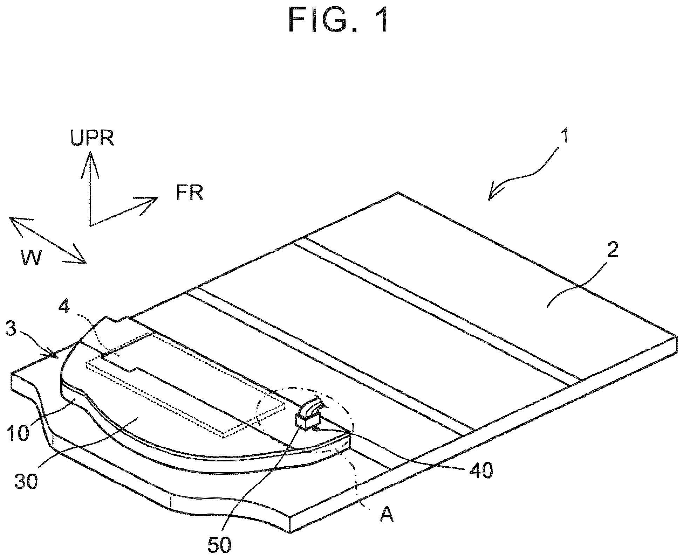

FIG. 1 is a perspective view illustrating an example of a power storage device including a connector assembly structure according to an embodiment of the present disclosure. The assembly structure according to the present embodiment can be employed in an appropriate position in a power storage device 1 such as illustrated in FIG. 1. The power storage device 1 may be capable of being installed at an appropriate position of a vehicle, such as on a floor for example, and may include a battery unit 2 having a plurality of power storage cells therein, which is omitted from illustration, and an equipment unit 3 that is provided on an upper portion of the battery unit 2. Note that in FIG. 1, arrow FR corresponds to forward in the vehicle in which the power storage device 1 is installed, and similarly hereinafter, arrow UPR corresponds to upward in the vehicle, and arrow W corresponds to a width direction of the vehicle. Also, an up-down direction in the connector assembly structure according to the present embodiment is a direction along the arrow UPR, and similarly hereinafter, the width direction or a lateral direction is a direction along the arrow W.

The battery unit 2 can be configured by housing the power storage cells in a casing. For the power storage cells, lithium-ion batteries, lithium iron phosphate (LFP) batteries, all-solid-state batteries, or the like, can be used, but are not limited thereto in particular. Also, shapes and layout of the power storage cells are not limited in particular, either.

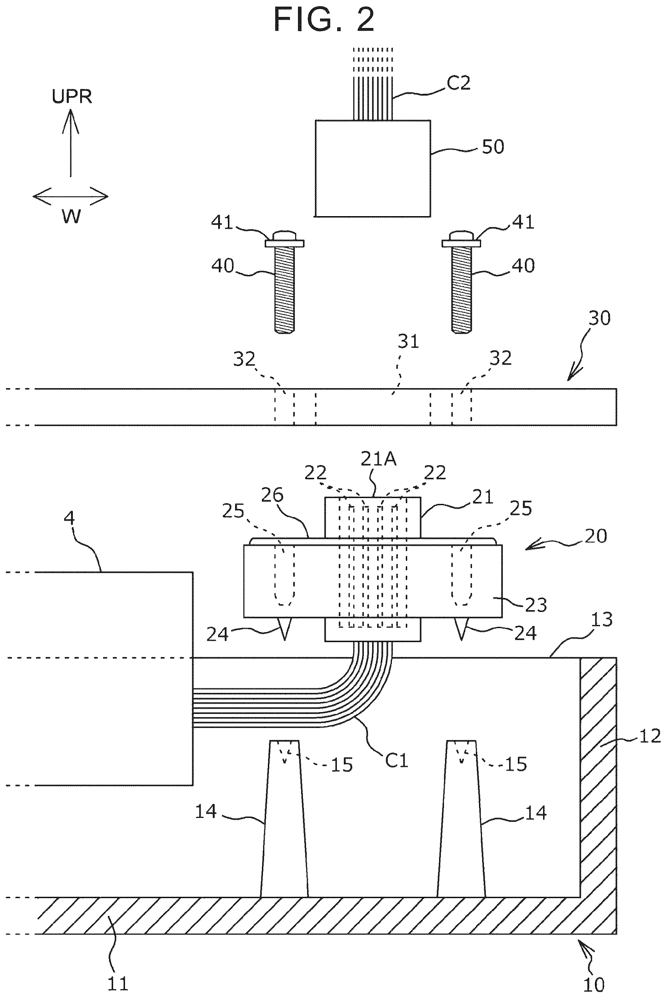

FIG. 2 is disassembled view of the principal portions of portion A that is illustrated in FIG. 1 in an enlarged manner. Note that in FIG. 2, a portion of a lower case 10 is illustrated in cross section to facilitate understanding of structures of each of the parts. The equipment unit 3 can be configured by housing equipment 4 that controls the components of the power storage device 1 in a casing including the lower case 10 and an upper case 30, as illustrated in FIGS. 1 and 2. The equipment 4 can selectively include one or more of, for example, a junction box that is connected to the power storage cells and controls charging and discharging thereof, a battery ECU that manages operations of the junction box, an on-board charger (OBC) that is used during charging, an inverter, a direct current (DC)-to-DC converter, or the like.

Also, in addition to the equipment 4 that is described above, the equipment unit 3 includes at least the lower case 10 making up part of the casing mentioned above, a male connector 20 serving as an example of a connector for electrically connecting the equipment 4 to external equipment that is omitted from illustration, the upper case 30 making up part of the casing, and bolts 40 serving as an example of a fixing member for fixing the male connector 20 to the upper case 30, as illustrated in FIG. 2.

The lower case 10 includes an equipment placement portion 11 on which the equipment 4 is placed, and one or a plurality of connector seats 14 provided at positions adjacent to the equipment placement portion 11. This lower case 10 can be configured as, for example, a box-like member having an opening 13 at the top thereof, so as to be capable of housing the equipment 4 therein. With respect to this, the equipment placement portion 11 can be configured from a plate material that makes up a bottom wall of the lower case 10. Also, a side wall 12 that extends upward may be provided on an outer periphery of the equipment placement portion 11. The lower case 10 can be made of a resin material or the like. Also, part of the equipment placement portion 11 may be provided with through holes or the like for wiring of cables or bus bars for electrically connecting the components in the battery unit 2 to the equipment 4, although these are omitted from illustration.

The connector seats 14 that are provided on the lower case 10 are seats that are provided for installing the male connector 20, and can be configured as projections extending upward from appropriate positions on the equipment placement portion 11. In the present embodiment, a case is exemplified in which two connector seats 14 are provided at positions where the male connector 20 is to be installed. It is preferable that upper faces of the connector seats 14 be configured as substantially horizontal faces, such that the male connector 20 can be stably placed thereon. In addition, the upper faces of the connector seats 14 may be provided with recessed portions 15 into which projections 24, serving as an example of a positioning portion of the male connector 20 that is described below, can be fitted.

The male connector 20 is a connector having terminals 22 that are connected to the equipment 4 via a cable C1. This male connector 20 includes a connector body 21 in which a plurality of the terminals 22 is housed therein, and the projections 24 serving as an example of a positioning portion provided on the connector body 21. In the present embodiment, a structure is exemplified in which a plurality of conducting lines in the cable C1 is connected to respective terminals 22 in the male connector 20, and the number of conducting lines in the cable C1 and the number of terminals 22 can be adjusted as appropriate.

The connector body 21 can be configured as a connector housing into which the cable C1 is inserted at one end thereof, with the other end of the connector housing opposite the one end thereof into which the cable C1 is inserted functioning as a fitting portion 21A to which a female connector 50, which will be described later, can be fitted. Inside this connector body 21, the terminals 22 that are pin-like and made of a conductive material may be arrayed at predetermined intervals from one another so as to extend from one end of the connector body 21 to the other end thereof. Also, base end portions of the terminals 22 may be electrically connected to the conducting lines of the cable C1. The portion of the connector body 21 making up the fitting portion 21A described above may be provided with openings into which terminals (omitted from illustration) on the female connector 50 side can be inserted when the female connector 50 is fitted.

Further, a flange 23 may be provided on an outer peripheral face of the connector body 21, extending in a direction intersecting an extending direction of the terminals 22. A face of the flange 23 that is adjacent to one end into which the cable C1 is inserted (hereinafter, this face will be referred to as "lower face of the flange 23") functions as a placing face that is placed on the upper faces of the connector seats 14.

The positioning portions are provided on the lower face of the flange 23, to position the male connector 20 by engaging with the connector seats 14. More specifically, the projections 24 serving as an example of a positioning portion may be provided to position the male connector 20 in the lower case 10 by fitting into recessed portions 15 that are provided in the connector seats 14. The shape of the projections 24 is not limited in particular, as long as the shape is such that allows positioning of the male connector 20 in a state of being fitted into the recessed portions 15, but can be, for example, cone shapes or pin-like shapes. In relation to this, the shapes of the recessed portions 15 that are provided in the connector seats 14 are also preferably cone shapes or bottomed-hole shapes. Note that in the present embodiment, a case is exemplified in which the projections 24 are provided on the flange 23, but the layout of the projections 24 is not limited in particular. Also, in the present embodiment, a case is exemplified in which the flange 23 is provided with the projections 24 and the connector seats 14 are provided with the recessed portions 15, but the flange 23 may be provided with the recessed portions and the connector seats 14 may be provided with the projections.

Also, a plurality of screw holes 25 is preferably provided on the face of the flange 23 that is adjacent to the fitting portion 21A (hereinafter, this face will be referred to as "upper face of the flange 23"). Screw threads are preferably form on inner faces of the screw holes 25, such that the bolts 40, which will be described later, can be screwed thereinto. Note that the layout and number of the screw holes 25 can be changed as appropriate, in accordance with the number of bolts 40 that are used. Also, instead of providing the screw holes 25, nuts that can be fastened to the bolts 40 may be embedded in appropriate positions of the flange 23.

Further, an O-ring 26 serving as an example of a sealing member may be provided at a position of the connector body 21 facing the upper case 30, more specifically, on an outer side from the positions where the screw holes 25 are provided on the upper face of the flange 23. This O-ring 26 can block a gap between the connector body 21 and the upper case 30. Employing this O-ring 26 enables water and the like to be suppressed from entering into the equipment unit 3. Note that while a case of the O-ring 26 that is provided on the male connector 20 side has been exemplified in the present embodiment, an O-ring can also be provided, instead of or in addition to this, in a position of the connector body 21 facing the upper case 30, on the upper face of the flange 23 for example. In addition, while a case of employing the O-ring 26 as the sealing member has been exemplified in the present embodiment, but sealing means other than the O-ring can also be employed as long as it is capable of sealing between the members.

The male connector 20 that is described above can be fit with the female connector 50 that is connected to the external equipment, omitted from illustration, via a cable C2, thereby electrically connecting the equipment 4 to the external device. The process of connecting the male connector 20 and the female connector 50 will be described later.

The upper case 30 can be configured as a substantially plate-like lid that covers the upper portion of the lower case 10, more specifically, the opening 13 of the lower case 10, so as to close it off. This upper case 30 includes a window portion 31 in which the male connector 20 is attached. Also, similar to the lower case 10, the upper case 30 can be made of a resin material or the like. Note that the specific shapes of the upper case 30 and the lower case 10 are not limited to the above-described structures as long as capable of housing the equipment 4.

The window portion 31 can be configured as a hole that passes through the upper case 30 in an up-down direction, and is adjusted in size such that at least a portion of the connector body 21 can be housed therein. This window portion 31 is provided in a position facing the fitting portion 21A of the male connector 20 that is installed on the connector seats 14 when the upper case 30 is attached to the lower case 10. Also, a plurality of through holes 32 into which the bolts 40 can be inserted is preferably provided around the window portion 31. These through holes 32 can be configured as holes having a thread therein, similar to that of the screw hole 25, or as a clearance hole having a diameter slightly larger than that of the screw hole 25.

The bolts 40 are for fixing the male connector 20 to the upper case 30. After the upper case 30 is attached to the lower case 10, the bolts 40 are inserted into the through holes 32 from outside of the upper case 30, more specifically, from above the upper case 30, and screwed into the screw holes 25. In the present embodiment, fixing the male connector 20 using two bolts 40 is exemplified. A washer 41 of which an outer diameter thereof is sufficiently larger than an inner diameter of the through hole 32 is preferably attached downward from a head of each of the bolts 40.

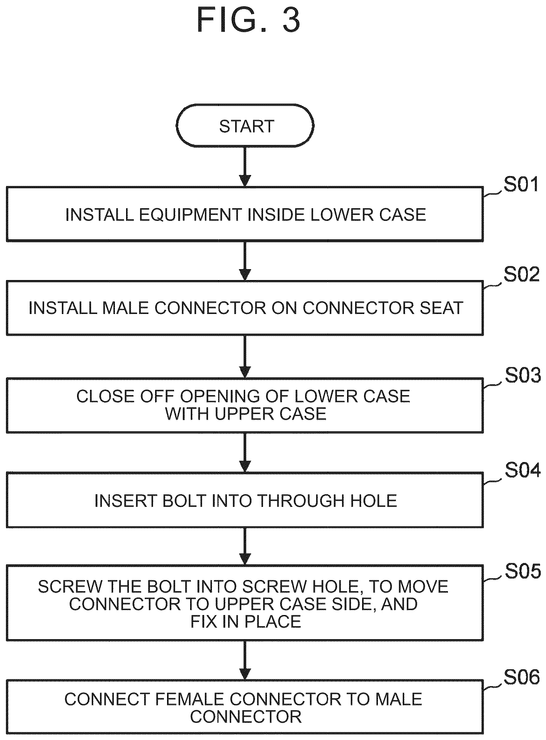

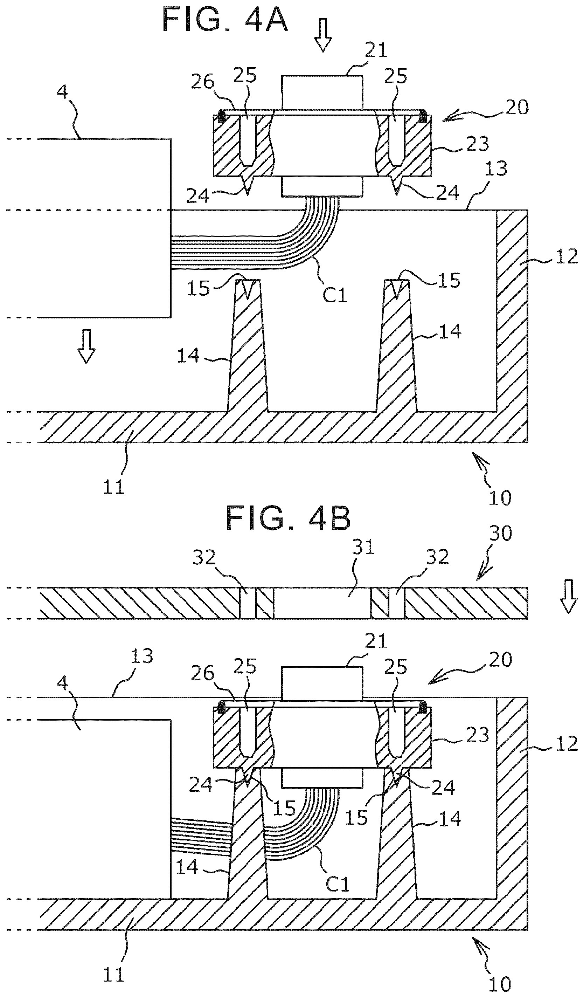

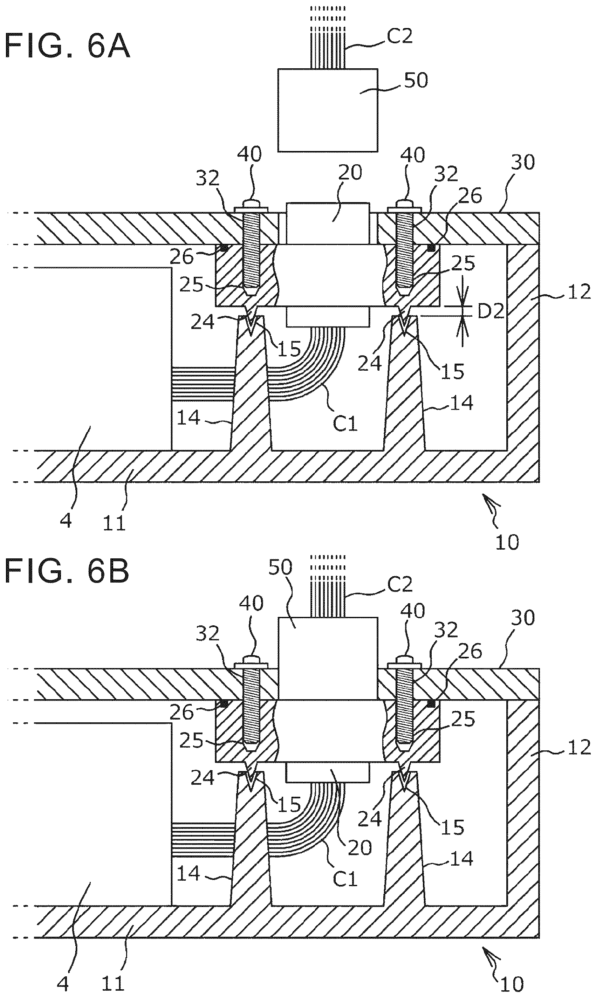

FIG. 3 is a flowchart showing an assembly process of the connector assembly structure that is illustrated in FIG. 2. Also, FIGS. 4A and 4B to 6A and 6B are explanatory diagrams illustrating the state of the connector assembly structure when the assembly process that is shown in FIG. 3 is carried out. Note that the explanatory diagrams that are illustrated in FIGS. 4A and 4B to 6A and 6B illustrate a greater part of the components in cross-section. Part of the assembly process of the power storage device 1, equipped with the connector assembly structure including the above-described components, will be described below as a connector assembly process. Note that the connector assembly process includes in particular, from among the processes for assembling the power storage device 1, processes from installation of the equipment 4 through electrically connecting the equipment 4 to an external device.

When the connector assembly process begins, as in FIGS. 3 and 4A, first, the equipment 4 is housed in the lower case 10 that is installed at a predetermined position on the upper portion of the battery unit 2, and the equipment 4 is installed in a predetermined position on the equipment placement portion 11 (step S01). Also, in conjunction with storing the equipment 4 inside the lower case 10 or after installing the equipment 4 in the lower case 10, the male connector 20 that is connected to the equipment 4 via the cable C1 is installed on the connector seat 14 (step S02). The male connector 20 is installed on the connector seats 14 by placing the lower face of the flange 23 of the male connector 20 on the upper faces of the connector seats 14. At this time, the male connector 20 may be positioned on the connector seats 14 by fitting the projections 24 that are provided on the flange 23 into the recessed portions 15 of the connector seats 14.

Note that the above-described step S02 is work that is performed in a state in which the opening 13 of the lower case 10 is open, and accordingly ease of work is enhanced. Also, the work of installing the male connector 20 on the connector seats 14 can be completed near the equipment 4, and accordingly there is hardly any need to ensure that the cable C1 has slack for the installation work.

After the installation of the male connector 20 is completed, the opening 13 of the lower case 10 is closed off by the upper case 30, as illustrated in FIG. 4B (step S03). This step can be realized, for example, by installing the upper case 30 on the upper portion of the lower case 10, and then fixing the upper case 30 to the lower case 10 using well-known fixing means such as screws or adhesive. Note that when installing the upper case 30 on the upper portion of the lower case 10, installation is preferably performed such that a portion of the male connector 20 is inserted into the window portion 31 of the upper case 30 and also such that the through holes 32 of the upper case 30 and the screw holes 25 of the male connector 20 are aligned in straight lines. Note that at the point in time that the upper case 30 is fixed to the lower case 10 described above, a gap D1 is formed between the upper face of the flange 23 and the inner face of the upper case 30 in the up-down direction. In other words, at the point in time that the upper case 30 is fixed to the lower case 10, the male connector 20 and the upper case 30 are in a state of being separated from each other, and the male connector 20 remains in a state of being placed on the connector seats 14.

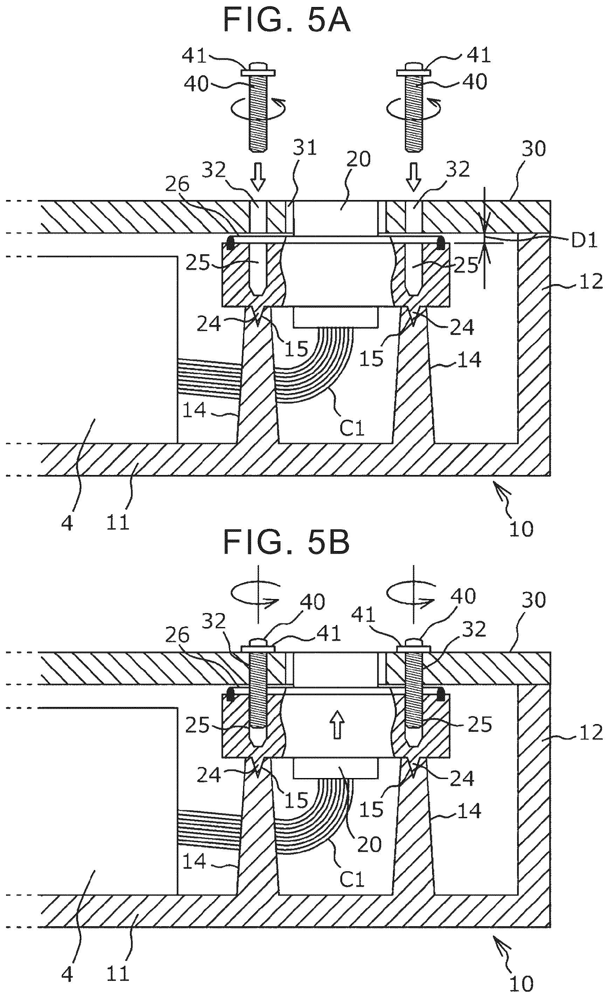

Once the upper case 30 has been fixed to the lower case 10, fixing work of fixing the upper case 30 and the male connector 20 to each other using the bolts 40 is started next. As illustrated in FIG. 5A, this fixing work begins by first inserting each of two bolts 40 into two through holes 32 that are provided in the upper case 30 (step S04), and then also rotating each bolt 40 to start fastening the bolts 40 to the screw holes 25.

As the fastening operation of the bolts 40 into the screw holes 25 progresses, the washers 41 of the bolts 40 come into contact with an upper face of the upper case 30, as illustrated in FIG. 5B, and downward movement of the bolts 40 stops. When the bolts 40 are then further rotated from the above state, the screwing of the bolts 40 and the screw holes 25 progress further, and the male connector 20 moves in a direction away from the connector seats 14, in other words, in a direction toward the upper case 30. Then, as the above-described screwing progresses, the inner face of the upper case 30 and the upper face of flange 23 come into contact with each other, whereby the male connector 20 can be fixed to the upper case 30 (step S05). At this time, a predetermined gap D2 is formed between the lower face of the flange 23 and the upper faces of the connector seats 14, as illustrated in FIG. 6A. As the gap D2 is formed, the engaged state between the projections 24 and the recessed portions 15 become disengaged.

In the above-described fastening operation of the bolts 40 and the screw holes 25, when the two bolts 40 are rotated simultaneously, the flange 23 can be moved while the upper face thereof maintains a substantially parallel attitude with the inner face of the upper case 30, which is preferable in that the movement can be carried out smoothly. However, the fastening operation may be performed by rotating the two bolts 40 separately.

As described above, in the connector assembly structure according to the present embodiment, it should be noted in particular that the work for fixing the male connector 20 to the upper case 30 can be performed from outside of the upper case 30. Being able to perform this work from outside of the upper case 30 not only improves ease of work, but also does away with the need to ensure a large amount of slack of the cable C1 to ensure the range of motion of the male connector 20 when performing fixing of the male connector 20 to the upper case 30. Also, the above-described assembly structure can be realized relatively easily by simply adding the connector seats 14, and accordingly there is substantially no increase in the number of parts required to realize the assembly structure.

In addition, rotating the bolts 40 and moving the male connector 20 in a direction approaching the upper case 30 enables the O-ring 26 can be clamped between the inner face of the upper case 30 and the upper face of the flange 23. This enables reliably suppressing a gap from occurring between the upper case 30 and the male connector 20.

In a state in which the male connector 20 is fixed to the upper case 30, the fitting portion 21A of the male connector 20 is exposed to outside of the upper case 30 through the window portion 31, as illustrated in FIG. 6A. Accordingly, connecting the female connector 50, which is connected to the external device, to the male connector 20 that is exposed from the window portion 31 (step S06) completes the connection between the equipment 4 and the external device (see FIG. 6B).

As described above, in the connector assembly structure according to the present embodiment, the assembly work between the upper case and the connector that is located inside the upper case can be carried out from the outside of the upper case. Thus, a structure with enhanced ease of work of assembly can be provided.

Note that in the above-described embodiment, a case of employing a male connector as an example of a connector is exemplified, but the type of connector is not limited in particular. For example, a female connector may be used in place of the male connector.

The present disclosure is not limited to the above-described embodiments, and can be carried out modified variously without departing from the spirit and scope of the present disclosure. All of these are included in the technical concept of the present disclosure. Also, unless otherwise specified in the specification, each component of the present disclosure is not limited to one, and may be present in multiple numbers.

## Claims

1. A connector assembly structure comprising:
equipment;
a lower case including an equipment placement portion on which the equipment is placed and one or a plurality of connector seats provided at a position that is adjacent to the equipment placement portion;
a connector that is connected to the equipment via a cable, and that includes a connector body in which a terminal is housed, and a positioning portion that is provided on the connector body and that engages the connector seat to position the connector;
an upper case that covers an upper portion of the lower case, and that has a window portion to which the connector is attached; and
a fixing member that is attached to a periphery of the window portion from outside of the upper case, and that moves the connector in a direction away from the connector seat and fixes the connector to the upper case.

2. The connector assembly structure according to claim 1, further comprising a seal member that is provided in at least one of a position of the connector body facing the upper case or a position of the upper case facing the connector body.

3. The connector assembly structure according to claim 1, wherein the connector body includes a flange extending from an outer peripheral face of the connector body in a direction intersecting with an extension direction of the terminal, and the positioning portion is provided on the flange.

4. The connector assembly structure according to claim 1, wherein
the connector seat includes a recessed portion or a projection on a face that comes into contact with the connector, and
the positioning portion includes a projection or a recessed portion that fits with the recessed portion or the projection that is fashioned in the connector seat.
